# FASCICULE DE BREVET EUROPEEN

(11) **EP 3 224 656 B1**
(45) Date de publication et mention de la délivrance du brevet: **09.01.2019**
(21) Numéro de dépôt: 14825398.2
(22) Date de dépôt: 28.11.2014
(51) Int. Cl.: G01V 99/00

(54) **PROCEDE DE DETERMINATION D'UN CUBE DE PROPORTION**
VERFAHREN ZUR BESTIMMUNG EINES KUBIKVERHÄLTNISSES
METHOD FOR DETERMINING A PROPORTION CUBE

(43) Date de publication de la demande: 04.10.2017
(73) Titulaire: Total SA, 92400 Courbevoie (FR)
(72) Inventeur: MASSONNAT, Gérard, F-64320 Idron (FR)
(74) Mandataire: Cabinet Plasseraud
(86) Numéro de dépôt international: PCT/FR2014/053085
(87) Numéro de publication internationale: WO 2016/083675

(56) Documents cités:
- US-A1- 2006 052 938
- US-A1- 2011 231 164
- CAERS J ET AL: "Probabilistic integration of geologic scenarios, seismic, and production data a West Africa turbidite reservoir case study", THE LEADING EDGE, SOCIETY OF EXPLORATION GEOPHYSICISTS, US, 1 mars 2006 (2006-03-01), pages 240-244, XP007902734, ISSN: 1070-485X, DOI: 10.1190/1.2184087
- BEUCHER H ET AL: "Using 3D seismic-derived information in lithofacies simulations. A case study", SPE ANNUAL TECHNICAL CONFERENCE AND EXHIBITION, XX, XX, vol. OMEGA, 3 octobre 1999 (1999-10-03), pages 581-592, XP002465166,

## Description

La présente invention concerne le domaine de la détermination de faciès géologique dans un sous-sol et dans le cadre de la recherche et de l'exploitation d'hydrocarbures et/ou de gaz.

La détermination des faciès géologiques dans un champ donné est utile dans le cadre de la recherche et de l'exploitation d'hydrocarbures ou de gaz car cette détermination permet d'estimer au mieux les ressources disponibles et, par voie de conséquence, la valeur économique du champ.

De plus, cette détermination permet d'établir des modèles fins concernant la production future du champ en fonction des paramètres de puits.

Il existe ainsi un grand nombre de techniques permettant d'établir des modèles de faciès à l'aide, par exemple :
- de forages,
- d'images sismiques,
- de simulations karstiques,
- de simulations géostatistiques,
- de connaissances conceptuelles des géologues (ex. gradient de faciès dans une direction de l'espace),
- etc.

Ces techniques peuvent être combinées afin d'obtenir des résultats plus précis.

Les proportions du modèle final pouvant influer sur le calcul des ressources en hydrocarbures ou en gaz, ces proportions sont suivies avec attention par les géologues.

Par exemple, il peut être souhaité de combiner certains modèles de facies donnant des probabilités (ou des tendances de probabilité) verticales (ou VPC pour « Vertical Proportion Cube » en anglais) et certains modèles de faciès donnant des probabilités (ou des tendances de probabilité) horizontales (ou HPC pour « Horizontal Proportion Cube » en anglais).

Par exemple, le document US 2006/0052938 propose de calculer des valeurs de proprortion associées aux cellules du cube de proportion combiné en utilsant la loi de transformation exponentielle (« power transformation law »).Les modèles de faciès modélisant n faciès sont souvent constitués de n cubes de proportion, chaque cube étant associé à un faciès. Pour une maille du modèle, la somme des proportions des différents faciès (indiquées par une maille correspondante de leur cube de proportion associé) est égale à 1.

Aujourd'hui, aucune solution efficace de l'état de la technique de solution ne permet une telle combinaison. Si des solutions peuvent être envisagées afin de combiner deux modèles de probabilité différentes (ex. des modèles HPC et des modèles VPC), la présence d'une seule probabilité nulle dans un de ces modèles donne le plus souvent une probabilité nulle dans le modèle de probabilité finale, ce qui peut être problématique ou introduire un biais.

De plus, il peut être difficile, après combinaison de modèles HPC et de modèles VPC, de conserver la contrainte mathématique selon laquelle chacune des lignes, et chacune des colonnes du modèle de proportion final doit sommer à 1. Ce non-respect de la contrainte mathématique peut provoquer des erreurs de modélisation importantes.

Il y a ainsi un besoin pour une méthode de combinaison de modèles HPC et VPC donnant des résultants satisfaisant sur le plan géologique et mathématique.

La présente invention vient améliorer la situation.

La présente invention vise alors un procédé de détermination d'un cube de proportion combiné à partir d'un premier cube de proportion maillé et d'un deuxième cube de proportion maillé pour chaque faciès i, d'un modèle géologique, i étant un entier entre 1 et I.

Chaque cube de proportion combiné, chaque premier cube de proportion maillé ou chaque deuxième cube de proportion maillé comprend des colonnes (105, 106) et chaque colonne comprend des cellules j (103, 104, 107, 108) dans la colonne, avec j un entier entre 1 et J.

Le procédé comporte les étapes, pour chaque faciès i courant parmi les faciès pris dans l'ordre i croissant :
- réception d'un premier cube de proportion maillé ;
- réception d'un deuxième cube de proportion maillé ;
- pour chaque colonne courante du cube de proportion combiné pour ledit faciès courant :
   - calculer une première valeur fonction d'une somme des valeurs de proportions associées aux cellules d'une colonne dudit premier cube correspondante à la colonne courante ;
   - calculer une deuxième valeur fonction d'une somme des valeurs de proportions associées aux cellules d'une colonne dudit second cube correspondant à la colonne courante ;
   - si la première valeur est inférieure ou égale à la deuxième valeur, associer à chaque cellule courante j parmi les cellules de la colonne courante prises dans l'ordre j croissant, une valeur de proportion minimale parmi :
      - une différence entre la première valeur calculée et la somme des valeurs de proportion associées aux cellules k de la colonne courante, avec k un entier dans l'intervalle [1, j-1] ;
      - une valeur de proportion associée à une cellule correspondante à la cellule courante dans le deuxième cube de proportion ;
      - une différence entre une valeur maximale prédéterminée et une somme des valeurs de proportion associées à une cellule correspondante pour chaque cube de proportion combiné d'un facies m avec m un entier dans l'intervalle [1,i-1] ;
   - si la première valeur est supérieure à la deuxième valeur, associer à chaque cellule courante j parmi les cellules de la colonne courante une valeur de proportion fonction de la moyenne d'une valeur de proportion associée à une cellule correspondante à la cellule courante dans le premier cube de proportion et d'une valeur de proportion associée à une cellule correspondante à la cellule courante dans le deuxième cube de proportion.

Bien entendu, l'index i des faciès peut être attribué de manière arbitraire à chacun des faciès possibles, du moment que cette indexation est constante durant l'exécution du processus.

J représente le nombre de cellules dans une colonne.

Dans un mode de réalisation de l'invention, le procédé peut également comporter en outre pour chaque faciès i courant parmi les faciès pris dans l'ordre i croissant :
- calculer une troisième valeur fonction d'une différence entre :
   - la deuxième valeur ;
   - et une somme des valeurs de proportions associées aux cellules de ladite colonne courante ;
- si la troisième valeur est inférieure à la première valeur, ajouter à la valeur de proportion associée à chaque cellule courante j parmi les cellules de la colonne courante prises dans l'ordre j croissant une valeur complémentaire minimale parmi :
   - une différence entre la valeur maximale prédéterminée et la valeur de proportion associée à la cellule courante
   - une différence entre la troisième valeur et la somme des valeurs complémentaires utilisées pour la cellule k, avec k un entier dans l'intervalle [1, j-1] ;
- si la troisième valeur est supérieure à la première valeur, ajouter à la valeur de proportion associée à chaque cellule courante j parmi les cellules de la colonne courante, une valeur complémentaire fonction de la moyenne d'une valeur de proportion associée à une cellule correspondante à la cellule courante dans le premier cube de proportion et d'une valeur de proportion associée à une cellule correspondante à la cellule courante dans le deuxième cube de proportion.

Ainsi, la présente invention vise également un dispositif destiné à mettre en oeuvre le procédé précédent.

Un programme informatique, mettant en oeuvre tout ou partie du procédé décrit ci-avant, installé sur un équipement préexistant, est en lui-même avantageux.

Ainsi, la présente invention vise également un programme informatique comportant des instructions pour la mise en oeuvre du procédé précédemment décrit, lorsque ce programme est exécuté par un processeur.

Ce programme peut utiliser n'importe quel langage de programmation (par exemple, un langage objet ou autre), et être sous la forme d'un code source interprétable, d'un code partiellement compilé ou d'un code totalement compilé.

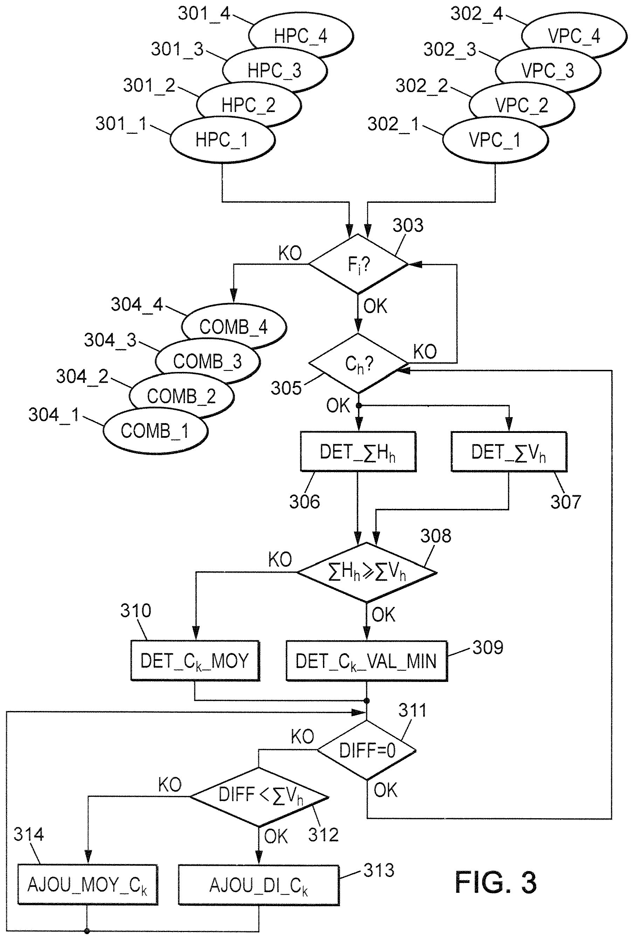

La figure 3, décrite en détails ci-après, peut former l'organigramme de l'algorithme général d'un tel programme informatique.

D'autres caractéristiques et avantages de l'invention apparaîtront encore à la lecture de la description qui va suivre. Celle-ci est purement illustrative et doit être lue en regard des dessins annexés sur lesquels :
- la figure 1a et la figure 1b illustrent des cubes de proportions d'entrée (donnant des tendances de probabilité verticales - VPC - ou donnant des tendances de probabilité horizontales - HPC) ;
- la figure 2 illustre une colonne de cube pour plusieurs facies permettant d'illustrer les différents calculs d'un mode de réalisation de l'invention ;
- la figure 3 illustre un organigramme d'un mode de réalisation de l'invention ;
- la figure 4 décrit un dispositif apte à mettre en oeuvre un mode de réalisation de l'invention.

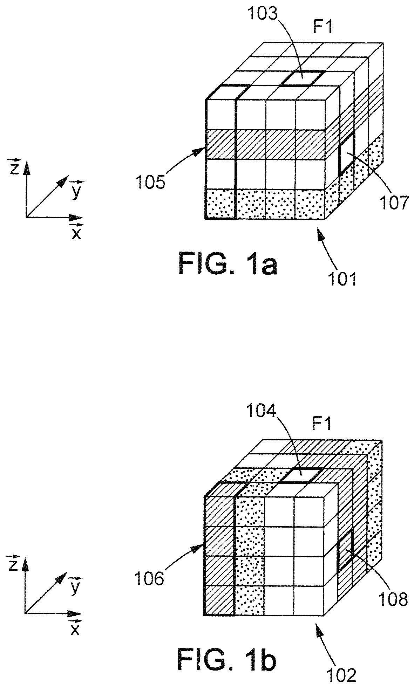

La figure 1a et la figure 1b illustrent des cubes de proportions d'entrée (donnant des tendances de probabilité verticales - VPC - ou donnant des tendances de probabilité horizontales - HPC).

La figure 1a illustre en effet un cube de proportion de 4 cellules x 4 cellules x 4 cellules et donnant des tendances verticales de proportion du faciès d'indice 1 (F1) dans le modèle. On appelle ce cube le cube VPC.

La figure 1b illustre en effet un cube de proportion de même dimensions que le cube VPC et donnant des tendances horizontales de proportion du faciès d'indice 1 (F1) dans le modèle. On appelle ce cube le cube HPC.

Le cube VPC et le cube HPC possèdent des colonnes pouvant être mis en correspondance deux à deux (i.e. celles qui possèdent les mêmes coordonnées dans le plan (x,y), par exemple 105 et 106).

Le cube combiné est un cube (obtenu par combinaison des cubes HPC et VPC) représentant le modèle de faciès final et possédant également les mêmes dimensions. Ainsi, il est également possible de définir de la même façon des colonnes correspondantes entre ce cube combiné et les cubes HPC-VPC.

Par analogie, il est possible de définir des cellules correspondantes entre le cube HPC et le cube VPC (ou le cube combiné) comme étant deux cellules ayant les mêmes coordonnées dans le référentiel (x,y,z). A titre d'illustration, les cellules 103 et 104 sont correspondantes (comme 107 et 108).

La figure 3 illustre un organigramme d'un mode de réalisation de l'invention. Dans ce mode de réalisation, il est considéré que le modèle peut comporter quatre faciès ou quatre types de faciès différents. On peut identifier les facies grâce à un index i compris entre 1 et 4.

Il est ainsi possible de recevoir, pour chacun des faciès i, un premier cube de proportion maillé (302_1, 302_2, 302_3, 302_4) et un deuxième cube de proportion maillée (301_1, 301_2, 301_3, 301_4).

Si certains faciès parmi les faciès 1 à 4 n'ont pas été traités (test 303, sortie OK), il est possible de sélectionner un de ces facies non-traités i et d'effectuer les étapes du procédé décrit ci-après pour ce faciès i.

Dans le cas contraire (test 303, sortie KO), il est possible de retourner l'ensemble des cubes de proportion combinés (304_1, 304_2, 304_3, 304_4) calculés comme suit.

Une fois un faciès i sélectionné, il est possible de choisir une colonne h parmi les colonnes non traitées pour ce faciès du cube de proportion combiné (test 305, sortie OK). Si toutes les colonnes du cube de proportion combiné ont été traitées pour ce faciès i (test 305, sortie KO), le test 303 est ré-exécuté.

Une fois une colonne h sélectionnée, il est possible de déterminer une première valeur (étape 307) fonction d'une somme des valeurs de proportions associées aux cellules d'une colonne du cube VPC correspondante à la colonne h sélectionnée. Cette valeur peut être égale à cette somme.

Il est également possible de calculer une deuxième valeur (étape 306) fonction d'une somme des valeurs de proportions associées aux cellules d'une colonne du cube HPC et correspondant à la colonne courante. Cette valeur peut être égale à cette somme.

Un exemple de calcul de la première et deuxième valeur est donné ci-dessous.

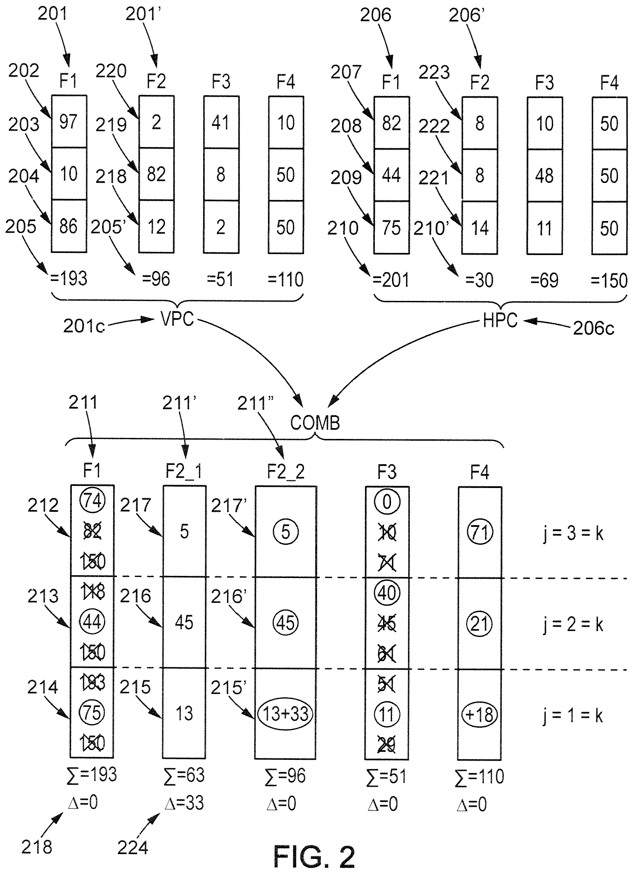

En référence à la Figure 2, les quatre colonnes 201c sont quatre colonnes correspondantes de quatre cubes VPC de proportions associés à quatre faciès F1, F2, F3 et F4. Chaque colonne comprend trois cellules possédant chacune une valeur. Par exemple, la colonne 201 comprend les valeurs 86 (élément 204), 10 (élément 203) et 97 (élément 202) (de bas en haut). Les quatre colonnes 206c sont quatre colonnes correspondantes de quatre cubes HPC de proportions associés à quatre faciès F1, F2, F3 et F4. Chaque colonne comprend trois cellules possédant chacune une valeur. Par exemple, la colonne 206 comprend les valeurs 75 (élément 75), 44 (élément 208) et 82 (élément 207) (de bas en haut).

En supposant que le faciès sélectionné est le faciès F1 et que la colonne sélectionnée a comme colonne correspondante les colonnes 201 et 206 dans les cubes de proportion VPC et HPC, la première valeur peut être la somme des éléments 202, 203 et 204 soit 193 (i.e. 97+10+86, élément 205). De même, la deuxième valeur peut être la somme des éléments 207, 208 et 209 soit 201 (i.e. 82+44+75, élément 210).

En supposant que le faciès sélectionné est le faciès F2 et que la colonne sélectionnée a comme colonne correspondante les colonnes 201' et 206' dans les cubes de proportion VPC et HPC, la première valeur peut être 96 (i.e. 12+82+2, élément 205'). De même, la deuxième valeur peut être 30 (i.e. 14+8+8, élément 210').

Si la première valeur est inférieure ou égale à la deuxième valeur (ce qui est le cas pour la situation présentée ci-dessus avec le faciès F1) (test 308, sortie OK), il associer (étape 309) à chaque cellule courante k parmi les cellules de la colonne sélectionnée (élément 211 de la figure 2 pour le faciès F1) du cube de proportion combiné prises dans l'ordre j croissant (i.e., en référence à la figure 2, de la cellule de la colonne la plus basse, à la cellule la plus haute dans la cellule), une valeur de proportion minimale parmi :
- a = une différence entre la première valeur calculée (i.e. 193 en référence à la figure 2 pour le faciès 1) et la somme des valeurs de proportion associées aux cellules k de la colonne courante, avec k un entier dans l'intervalle [1, j-1] (i.e. la somme des valeurs des cellules sous la cellule courante k) ;
- b = la valeur de proportion associée à une cellule correspondante à la cellule courante dans le cube de proportion HPC ;
- c = une différence entre une valeur maximale prédéterminée (i.e. la valeur maximale de la cellule, par exemple 1 ou 100) et une somme des valeurs de proportion associées à une cellule correspondante pour chaque cube de proportion combiné d'un facies m avec m un entier dans l'intervalle [1,i-1] (c'est-à-dire pour l'ensemble des cellules correspondantes des cubes combinée ayant un faciès ayant déjà été traité).

Par exemple, dans l'exemple donné ci-dessus pour le faciès F1 et en relation avec la figure 2, la cellule 214 de la colonne 211 du cube de proportion combiné pour le faciès F1 se voit attribuer trois valeurs a, b, c avec a=193 (car aucune cellule n'est située sous cette cellule 214 dans la colonne 211), avec b=75 (car la cellule 209 correspondante dans le cube HPC pour le faciès F1 a également cette valeur) et c=150 (car il est supposé ici que la valeur maximale prédéterminé vaut 150, aucun autre faciès n'ayant été traité). La valeur minimale parmi a, b et c est ici b. Ainsi, est associée à la cellule 214 la valeur 75.

La cellule 213 de la colonne 211 du cube de proportion combiné pour le faciès F1 se voit attribuer trois valeurs a, b, c avec a=118 (i.e. 193-75 car la valeur 193 est la première valeur calculée et la valeur 75 a été attribuée à la cellule 214 située en dessous de la cellule 213), avec b=44 (car la cellule 208 correspondante dans le cube HPC pour le faciès F1 a également cette valeur) et c=150 (car il est supposé ici que la valeur maximale prédéterminé vaut 150, aucun autre faciès n'ayant été traité). La valeur minimale parmi a, b et c est ici b. Ainsi, est associée à la cellule 213 la valeur 44.

La cellule 212 de la colonne 211 du cube de proportion combiné pour le faciès F1 se voit attribuer trois valeurs a, b, c avec a=74 (i.e. 193-75-44 car la valeur 193 est la première valeur calculée, la valeur 75 a été attribuée à la cellule 214, la valeur 44 a été attribué à la cellule 213, les cellules 214 et 213 étant situées en dessous de la cellule 212), avec b=82 (car la cellule 207 correspondante dans le cube HPC pour le faciès F1 a également cette valeur) et c=150 (car il est supposé ici que la valeur maximale prédéterminé vaut 150, aucun autre faciès n'ayant été traité). La valeur minimale parmi a, b et c est ici a. Ainsi, est associée à la cellule 212 la valeur 74.

Si la première valeur est supérieure à la deuxième valeur (ce qui est le cas pour la situation présentée ci-dessus avec le faciès F2) (test 308, sortie KO), associer (étape 310) à chaque cellule courante parmi les cellules de la colonne courante une valeur de proportion fonction de la moyenne d'une valeur de proportion associée à une cellule correspondante à la cellule courante dans le premier cube de proportion et d'une valeur de proportion associée à une cellule correspondante à la cellule courante dans le deuxième cube de proportion. La valeur de proportion associée peut être cette moyenne. Cette moyenne peut être également multiplié par un facteur C compris dans l'intervalle [0 ; 1].

Par exemple, dans l'exemple donné ci-dessus pour le faciès F2 et en relation avec la figure 2, la cellule 215 de la colonne 211' du cube de proportion combiné pour le faciès F2 se voit attribuer, dans un premier temps, la valeur 13 (moyenne de la valeur 12 de la cellule correspondante 218 et de la valeur 14 de la cellule correspondante 221).

La cellule 216 de la colonne 211' du cube de proportion combiné pour le faciès F2 se voit attribuer, dans un premier temps, la valeur 45 (moyenne de la valeur 82 de la cellule correspondante 219 et de la valeur 8 de la cellule correspondante 222).

La cellule 217 de la colonne 211' du cube de proportion combiné pour le faciès F2 se voit attribuer, dans un premier temps, la valeur 5 (moyenne de la valeur 2 de la cellule correspondante 220 et de la valeur 8 de la cellule correspondante 223).

En outre, il est possible de calculer une troisième valeur (DIFF) fonction d'une différence entre la deuxième valeur et une somme des valeurs de proportions associées aux cellules de ladite colonne courante.

A titre d'illustration et en référence à la figure 2, cette troisième valeur vaut 0 (élément 218) pour le faciès F1. Cette troisième valeur vaut 33 (élément 224) pour le faciès F2.

Si cette troisième valeur vaut 0 (test 311, sortie OK), il est possible de changer de colonne (i.e. retour au test 305).

Si cette troisième valeur ne vaut pas 0 (test 311, sortie KO), il est possible de chercher à modifier les valeurs associées aux cellules de la colonne courantes du cube de proportion combiné comme suit.

Si la troisième valeur est inférieure à la deuxième valeur (test 312, sortie OK), il est possible d'ajouter (étape 313) à la valeur de proportion associée à chaque cellule courante j parmi les cellules de la colonne courante prises dans l'ordre j croissant une valeur complémentaire minimale parmi :
- d = une différence entre la valeur maximale prédéterminée (i.e. 150 dans l'exemple de la Figure 2) et la valeur de proportion associée à la cellule courante (i.e. celle associée précédemment) ;
- e = une différence entre la troisième valeur et la somme des valeurs complémentaires utilisées pour la cellule k, avec k un entier dans l'intervalle [1, j-1] (c'est-à-dire, la somme des valeurs complémentaires pour les cellules situées en dessous de la cellule j).

Dans l'exemple de la figure 2, les valeurs de la colonne 211' sont modifiées car la troisième valeur calculée vaut 33 (élément 224, i.e. différent de 0 et supérieure à la première valeur 205' qui vaut 96). Pour la cellule 215, la valeur d vaut 150-13 et la valeur e vaut 33-0. Ainsi, la valeur 13 associée à la cellule 215 de la colonne 211' est transformée en la valeur 13+33 (élément 215'), 33 étant la valeur minimale entre d et e.

Pour la cellule 216, la valeur d vaut 150-45 et la valeur e vaut 33-33. Ainsi, la valeur 45 associée à la cellule 216 de la colonne 211' est transformée en la valeur 13+0 (élément 216'), 0 étant la valeur minimale entre d et e.

Pour la cellule 217, la valeur d vaut 150-5 et la valeur e vaut 33-33-0. Ainsi, la valeur 5 associée à la cellule 217 de la colonne 211' est transformée en la valeur 5+0 (élément 217'), 0 étant la valeur minimale entre d et e.

Si la troisième valeur est supérieure à la première valeur (test 312, sortie KO), il est possible d'ajouter à la valeur de proportion associée à chaque cellule courante j parmi les cellules de la colonne courante, une valeur complémentaire fonction de la moyenne d'une valeur de proportion associée à une cellule correspondante à la cellule courante dans le premier cube de proportion et d'une valeur de proportion associée à une cellule correspondante à la cellule courante dans le deuxième cube de proportion.

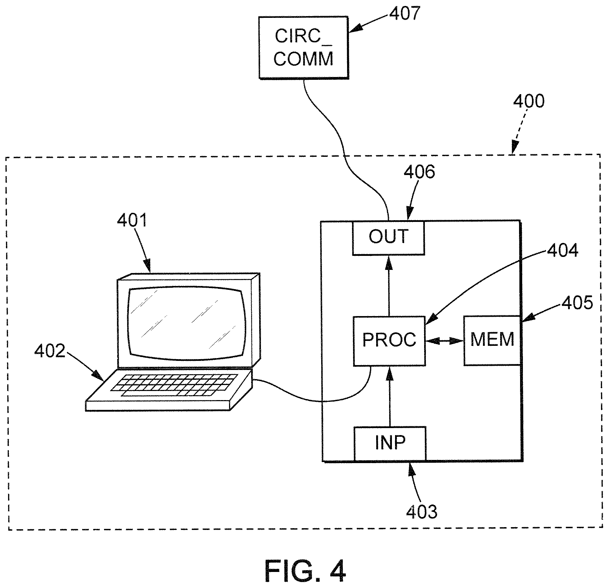

La figure 4 représente un exemple de dispositif permettant la mise en oeuvre d'un mode de réalisation de l'invention.

Dans ce mode de réalisation, le dispositif comporte un ordinateur 400, comprenant une mémoire 405 pour stocker des instructions permettant la mise en oeuvre du procédé, les données de mesures reçues, et des données temporaires pour réaliser les différentes étapes du procédé tel que décrit précédemment.

L'ordinateur comporte en outre un circuit 404. Ce circuit peut être, par exemple :
- un processeur apte à interpréter des instructions sous la forme de programme informatique, ou
- une carte électronique dont les étapes du procédé de l'invention sont décrites dans le silicium, ou encore
- une puce électronique programmable comme une puce FPGA (pour « Field-Programmable Gate Array » en anglais).

Cet ordinateur comporte une interface d'entrée 403 pour la réception de données de mesures, et une interface de sortie 406 pour la fourniture du cube de proportion combiné à un dispositif de traitement 407 (pouvant être également le dispositif 400). Enfin, l'ordinateur peut comporter, pour permettre une interaction aisée avec un utilisateur, un écran 401 et un clavier 402. Bien entendu, le clavier est facultatif, notamment dans le cadre d'un ordinateur ayant la forme d'une tablette tactile, par exemple.

Par ailleurs, le schéma fonctionnel présenté sur la figure 3 est un exemple typique d'un programme dont certaines instructions peuvent être réalisées auprès de l'équipement 400 décrit. A ce titre, la figure 3 peut correspondre à l'organigramme de l'algorithme général d'un programme informatique au sens de l'invention.

Bien entendu, la présente invention ne se limite pas aux formes de réalisation décrites ci-avant à titre d'exemples ; elle s'étend à d'autres variantes qui ressortent des revendications annexées.

Par exemple, dans les figures 2 et 3, seuls quatre faciès sont considérés mais ces modes de réalisations se généralisent sans difficulté à un nombre plus faible ou plus élevé de faciès.

## Revendications

1. Procédé, mis en oeuvre par ordinateur, de détermination d'un cube de proportion combiné à partir d'un premier cube de proportion maillé, donnant des tendances de probabilités verticales, et d'un deuxième cube de proportion maillé, donnant des tendances de probabilités horizontales, pour chaque faciès i, d'un modèle géologique, i étant un entier entre 1 et I,
chaque cube de proportion combiné, chaque premier cube de proportion maillé ou chaque deuxième cube de proportion maillé comprend des colonnes (105, 106) et chaque colonne comprend des cellules j (103, 104, 107, 108) dans la colonne, avec j un entier entre 1 et J,
le procédé comportant les étapes, pour chaque faciès i courant parmi les faciès pris dans l'ordre i croissant :
- réception d'un premier cube de proportion maillé (101) ;
- réception d'un deuxième cube de proportion maillé (102) ;
**caractérisé en ce que**:
- pour chaque colonne courante du cube de proportion combiné pour ledit faciès courant :
- calculer une première valeur (205) fonction d'une somme des valeurs de proportions associées aux cellules (202, 203, 204) d'une colonne (201) dudit premier cube (101) correspondante à la colonne courante ;
- calculer une deuxième valeur (210) fonction d'une somme des valeurs de proportions associées aux cellules (207, 208, 209) d'une colonne (206) dudit second cube (102) correspondant à la colonne courante ;
- si la première valeur (205) est inférieure ou égale à la deuxième valeur (210), associer à chaque cellule courante j parmi les cellules de la colonne courante (212, 213, 214) prises dans l'ordre j croissant, une valeur de proportion minimale parmi :
- une différence (214a) entre la première valeur (205) calculée et la somme des valeurs de proportion associées aux cellules k de la colonne courante, avec k un entier dans l'intervalle [1, j-1];
- une valeur de proportion (214b) associée à une cellule correspondante à la cellule courante (209) dans le deuxième cube de proportion ;
- une différence (214c) entre une valeur maximale prédéterminée et une somme des valeurs de proportion associées à une cellule correspondante pour chaque cube de proportion combiné d'un facies m avec m un entier dans l'intervalle [1,i-1] ;
- si la première valeur (205) est supérieure à la deuxième valeur (210), associer à chaque cellule (215, 216, 217) courante j parmi les cellules de la colonne courante une valeur de proportion fonction de la moyenne d'une valeur de proportion associée à une cellule correspondante (204, 203, 202) à la cellule courante dans le premier cube de proportion et d'une valeur de proportion associée à une cellule correspondante (209, 208, 207) à la cellule courante dans le deuxième cube de proportion.

2. Procédé selon la revendication 1, dans lequel le procédé comporte en outre pour chaque faciès i courant parmi les faciès pris dans l'ordre i croissant :
- calculer une troisième valeur (218) fonction d'une différence entre :
- la deuxième valeur ;
- et une somme des valeurs de proportions associées aux cellules de ladite colonne courante ;
- si la troisième valeur (218) est inférieure à la première valeur (210), ajouter à la valeur de proportion associée à chaque cellule courante j parmi les cellules de la colonne courante prises dans l'ordre j croissant une valeur complémentaire minimale parmi :
- une différence entre la valeur maximale prédéterminée et la valeur de proportion associée à la cellule courante
- une différence entre la troisième valeur (218) et la somme des valeurs complémentaires utilisées pour la cellule k, avec k un entier dans l'intervalle [1, j-1] ;
- si la troisième valeur (218) est supérieure à la première valeur, ajouter à la valeur de proportion associée à chaque cellule courante j parmi les cellules de la colonne courante, une valeur complémentaire fonction de la moyenne d'une valeur de proportion associée à une cellule correspondante à la cellule courante dans le premier cube de proportion et d'une valeur de proportion associée à une cellule correspondante à la cellule courante dans le deuxième cube de proportion.

3. Dispositif, comportant un ordinateur, de détermination d'un cube de proportion combiné à partir d'un premier cube de proportion maillé, donnant des tendances de probabilités verticales, et d'un deuxième cube de proportion maillé, donnant des tendances de probabilités horizontales, pour chaque faciès i, d'un modèle géologique, i étant un entier entre 1 et I,
chaque cube de proportion combiné, chaque premier cube de proportion maillé ou chaque deuxième cube de proportion maillé comprend des colonnes (105, 106) et chaque colonne comprend des cellules j (103, 104, 107, 108) dans la colonne, avec j un entier entre 1 et J,
le dispositif comportant, pour chaque faciès i courant parmi les faciès pris dans l'ordre i croissant :
- une première interface (403) pour la réception d'un premier cube de proportion maillé (101) ;
- une deuxième interface (403) pour la réception d'un deuxième cube de proportion maillé (102) ;
**caractérisé en ce que**:
- un circuit (404) adapté pour, pour chaque colonne courante du cube de proportion combiné pour ledit faciès courant :
- calculer une première valeur (205) fonction d'une somme des valeurs de proportions associées aux cellules (202, 203, 204) d'une colonne (201) dudit premier cube (101) correspondante à la colonne courante ;
- calculer une deuxième valeur (210) fonction d'une somme des valeurs de proportions associées aux cellules (207, 208, 209) d'une colonne (206) dudit second cube (102) correspondant à la colonne courante ;
- si la première valeur (205) est inférieure ou égale à la deuxième valeur (210), associer à chaque cellule courante j parmi les cellules de la colonne courante (212, 213, 214) prises dans l'ordre j croissant, une valeur de proportion minimale parmi :
- une différence (214a) entre la première valeur (205) calculée et la somme des valeurs de proportion associées aux cellules k de la colonne courante, avec k un entier dans l'intervalle [1, j-1];
- une valeur de proportion (214b) associée à une cellule correspondante à la cellule courante (209) dans le deuxième cube de proportion ;
- une différence (214c) entre une valeur maximale prédéterminée et une somme des valeurs de proportion associées à une cellule correspondante pour chaque cube de proportion combiné d'un facies m avec m un entier dans l'intervalle [1,i-1];
- si la première valeur (205) est supérieure à la deuxième valeur (210), associer à chaque cellule (215, 216, 217) courante j parmi les cellules de la colonne courante une valeur de proportion fonction de la moyenne d'une valeur de proportion associée à une cellule correspondante (204, 203, 202) à la cellule courante dans le premier cube de proportion et d'une valeur de proportion associée à une cellule correspondante (209, 208, 207) à la cellule courante dans le deuxième cube de proportion.

4. Produit programme informatique comportant des instructions pour la mise en oeuvre du procédé selon l'une des revendications 1 à 2, lorsque ce programme est exécuté par un processeur.

## Patentansprüche

1. Von einem Computer durchzuführendes Verfahren zur Bestimmung eines kombinierten Verhältniskubus ausgehend von einem vertikale Wahrscheinlichkeitstendenzen bereitstellenden, ersten maschigen Verhältniskubus und einem horizontale Wahrscheinlichkeitstendenzen bereitstellenden, zweiten maschigen Verhältniskubus für jede Fazies i eines geologischen Modells, wobei i eine ganze Zahl zwischen 1 und I ist,
wobei jeder kombinierte Verhältniskubus, jeder erste maschige Verhältniskubus oder jeder zweite maschige Verhältniskubus Säulen (105, 106) aufweist und jede Säule Zellen j (103, 104, 107, 108) in der Säule aufweist, wobei j eine ganze Zahl zwischen 1 und J ist,
wobei das Verfahren die Schritte aufweist:
für jede aktuelle Fazies i aus den in aufsteigender Reihenfolge i herausgegriffenen Fazies:
- Empfangen eines ersten maschigen Verhältniskubus (101);
- Empfangen eines zweiten maschigen Verhältniskubus (102),
**gekennzeichnet durch**:
- für jede aktuelle Säule des kombinierten Verhältniskubus für die aktuelle Fazies:
- Berechnen eines ersten Werts (205) als Funktion einer Summe der Verhältniswerte, die mit den Zellen (202, 203, 204) einer der aktuellen Säule entsprechenden Säule (201) des ersten Kubus (101) verknüpft sind;
- Berechnen eines zweiten Werts (210) als Funktion einer Summe der Verhältniswerte, die mit den Zellen (202, 203, 204) einer der aktuellen Säule entsprechenden Säule (206) des zweiten Kubus (102) verknüpft sind;
- falls der erste Wert (205) kleiner oder gleich dem zweiten Wert (210) ist, Verknüpfen jeder aktuellen Zelle j der in aufsteigender Reihenfolge j herausgegriffenen Zellen (212, 213, 214) der aktuellen Säule mit einem Verhältniswert, der unter folgenden Werten der minimale ist:
- eine Differenz (214a) zwischen dem berechneten ersten Wert (205) und der Summe der Verhältniswerte, die mit den Zellen k der aktuellen Säule verknüpft sind, wobei k eine ganze Zahl in dem Intervall [1,j-1] ist;
- ein Verhältniswert (214b), der mit einer der aktuellen Zelle entsprechenden Zelle (209) in dem zweiten Verhältniskubus verknüpft ist;
- eine Differenz (214c) zwischen einem vorgegebenen maximalen Wert und einer Summe der Verhältniswerte, die mit einer entsprechenden Zelle für jeden kombinierten Verhältniskubus einer Fazies m verknüpft sind, wobei m eine ganze Zahl in dem Intervall [1, i-1] ist;
- falls der erste Wert (205) größer als der zweite Wert (210) ist, Verknüpfen jeder aktuellen Zelle j (215, 216, 217) der Zellen der aktuellen Säule mit einem Verhältniswert als Funktion des Mittelwerts zwischen einem Verhältniswert, der mit einer der aktuellen Zelle entsprechenden Zelle (204, 203, 202) in dem ersten Verhältniskubus verknüpft ist, und einem Verhältniswert, der mit einer der aktuellen Zelle entsprechenden Zelle (209, 208, 207) in dem zweiten Verhältniskubus verknüpft ist.

2. Verfahren nach Anspruch 1, in welchem das Verfahren ferner für jede aktuelle Fazies i aus den in aufsteigender Reihenfolge i herausgegriffenen Fazies aufweist:
- Berechnen eines dritten Werts (218) als Funktion einer Differenz zwischen:
- dem zweiten Wert;
- und einer Summe der mit den Zellen der aktuellen Säule verknüpften Verhältniswerte;
- falls der dritte Wert (218) kleiner als der erste Wert (210) ist, Addieren des Verhältniswerts, der mit jeder aktuellen Zelle j der in aufsteigender Reihenfolge j herausgegriffenen Zellen der aktuellen Säule verknüpft ist, mit einem komplementären Wert, der unter den folgenden der minimale ist:
- eine Differenz zwischen dem vorgegebenen maximalen Wert und dem mit der aktuellen Zelle verknüpften Verhältniswert;
- eine Differenz zwischen dem dritten Wert (218) und der Summe der für die Zelle k verwendeten komplementären Werte, wobei k eine ganze Zahl in dem Intervall [1, j-1] ist;
- falls der dritte Wert (218) größer als der erste Wert ist, Addieren des Verhältniswerts, der mit jeder aktuellen Zelle j der Zellen der aktuellen Säule verknüpft ist, mit einem komplementären Wert als Funktion des Mittelwerts zwischen einem Verhältniswert, der mit einer der aktuellen Zelle entsprechenden Zelle in dem ersten Verhältniskubus verknüpft ist, und einem Verhältniswerts, der mit einer der aktuellen Zelle entsprechenden Zelle in dem zweiten Verhältniskubus verknüpft ist.

3. Vorrichtung, aufweisend einen Computer, zur Bestimmung eines kombinierten Verhältniskubus ausgehend von einem vertikale Wahrscheinlichkeitstendenzen bereitstellenden, ersten maschigen Verhältniskubus und einem horizontale Wahrscheinlichkeitstendenzen bereitstellenden, zweiten maschigen Verhältniskubus für jede Fazies i eines geologischen Modells, wobei i eine ganze Zahl zwischen 1 und I ist,
wobei jeder kombinierte Verhältniskubus, jeder erste maschige Verhältniskubus oder jeder zweite maschige Verhältniskubus Säulen (105, 106) aufweist und jede Säule Zellen j (103, 104, 107, 108) in der Säule aufweist, wobei j eine ganze Zahl zwischen 1 und J ist,
wobei die Vorrichtung aufweist:
für jede aktuelle Fazies i aus den in aufsteigender Reihenfolge i herausgegriffenen Fazies:
- eine erste Schnittstelle (403) zum Empfangen eines ersten maschigen Verhältniskubus (101);
- eine zweite Schnittstelle (403) zum Empfangen eines zweiten maschigen Verhältniskubus (102),
**gekennzeichnet durch**:
- eine Schaltung (404), die eingerichtet ist, für jede aktuelle Säule des kombinierten Verhältniskubus für die aktuelle Fazies zum:
- Berechnen eines ersten Werts (205) als Funktion einer Summe der Verhältniswerte, die mit den Zellen (202, 203, 204) einer der aktuellen Säule entsprechenden Säule (201) des ersten Kubus (101) verknüpft sind;
- Berechnen eines zweiten Werts (210) als Funktion einer Summe der Verhältniswerte, die mit den Zellen (202, 203, 204) einer der aktuellen Säule entsprechenden Säule (206) des zweiten Kubus (102) verknüpft sind;
- falls der erste Wert (205) kleiner oder gleich dem zweiten Wert (210) ist, Verknüpfen jeder aktuellen Zelle j der in aufsteigender Reihenfolge j herausgegriffenen Zellen (212, 213, 214) der aktuellen Säule mit einem Verhältniswert, der unter folgenden Werten der minimale ist:
- eine Differenz (214a) zwischen dem berechneten ersten Wert (205) und der Summe der Verhältniswerte, die mit den Zellen k der aktuellen Säule verknüpft sind, wobei k eine ganze Zahl in dem Intervall [1, j-1] ist;
- ein Verhältniswert (214b), der mit einer der aktuellen Zelle entsprechenden Zelle (209) in dem zweiten Verhältniskubus verknüpft ist;
- eine Differenz (214c) zwischen einem vorgegebenen maximalen Wert und einer Summe der Verhältniswerte, die mit einer entsprechenden Zelle für jeden kombinierten Verhältniskubus einer Fazies m verknüpft sind, wobei m eine ganze Zahl in dem Intervall [1, i-1] ist;
- falls der erste Wert (205) größer als der zweite Wert (210) ist, Verknüpfen jeder aktuellen Zelle j (215, 216, 217) der Zellen der aktuellen Säule mit einem Verhältniswert als Funktion des Mittelwerts zwischen einem Verhältniswert, der mit einer der aktuellen Zelle entsprechenden Zelle (204, 203, 202) in dem ersten Verhältniskubus verknüpft ist, und einem Verhältniswert, der mit einer der aktuellen Zelle entsprechenden Zelle (209, 208, 207) in dem zweiten Verhältniskubus verknüpft ist.

4. Computerprogrammprodukt, aufweisend Befehle zum Implementieren des Verfahrens nach einem der Ansprüche 1 bis 2, wenn dieses Programm von einem Prozessor abgearbeitet wird.

## Claims

1. Computer implemented method of determining a combined proportion cube from a first meshed proportion cube, providing vertical probability trends, and a second meshed proportion cube, providing horizontal probability trends, for each facies i of a geological model, where i is an integer between 1 and I,
each combined proportion cube, each first meshed proportion cube or each second meshed proportion cube comprises columns (105, 106) and each column comprises cells j (103, 104, 107, 108) in the column, where j is an integer between 1 and J,
the method including the following steps for each current facies i among the facies taken in increasing order of i:
- receive a first meshed proportion cube (101);
- receive a second meshed proportion cube (102);
**characterized in that**:
- for each current column of the combined proportion cube for said current facies:
-- calculate a first value (205) that is a function of a sum of proportion values associated with the cells (202, 203, 204) of a column (201) in said first cube (101) corresponding to the current column;
-- calculate a second value (210) that is a function of a sum of proportion values associated with the cells (207, 208, 209) of a column (206) in said second cube (102) corresponding to the current column;
-- if the first value (205) is less than or equal to the second value (210), associate a proportion value with each current cell j among the cells in the current column (212, 213, 214) taken in increasing order of j, this proportion value being the minimum among:
--- a difference (214a) between the first calculated value (205) and the sum of proportion values associated with cells k in the current column, where k is an integer within the [1, j-1] interval;
--- a proportion value (214b) associated with a cell corresponding to the current cell (209) in the second proportion cube;
--- a difference (214c) between a maximum predetermined value and a sum of proportion values associated with a corresponding cell for each combined proportion cube for a facies m where m is an integer within the [1,i-1] interval;
-- if the first value (205) is larger than the second value (210), take each current cell j (215, 216, 217) among the cells in the current column and associate a proportion value with it, as a function of the average of a proportion value associated with a cell (204, 203, 202) corresponding to the current cell in the first proportion cube and a proportion value associated with a cell (209, 208, 207) corresponding to the current cell in the second proportion cube.

2. Method according to claim 1, in which method also includes the following steps for each current facies i among the facies taken in increasing order of i:
- calculate a third value (218) as a function of a difference between:
-- the second value;
-- and a sum of the proportion values associated with the cells in said current column;
- if the third value (218) is less than the first value (210), add a complementary value to the proportion value associated with each current cell j among the cells in the current column taken in increasing order of j, this complementary value being the minimum among:
-- a difference between the predetermined maximum value and the proportion value associated with the current cell
-- a difference between the third value (218) and the sum of complementary values used for cell k, where k is an integer within the [1,j-1] interval;
- if the third value (218) is larger than the first value, take the proportion value associated with each current cell j among the cells in the current column and add a complementary value to it, as a function of the average of a proportion value associated with a cell corresponding to the current cell in the first proportion cube and a proportion value associated with a cell corresponding to the current cell in the second proportion cube.

3. Device, comprising a computer, for determining a combined proportion cube from a first meshed proportion cube, providing vertical probability trends, and a second meshed proportion cube, providing horizontal probability trends, for each facies i of a geological model, where i is an integer between 1 and I,
each combined proportion cube, each first meshed proportion cube or each second meshed proportion cube comprises columns (105, 106) and each column comprises cells j (103, 104, 107, 108) in the column, where j is an integer between 1 and J,
the device comprising the following for each current facies i among the facies taken in increasing order of i:
- a first interface (403) for the reception of a first meshed proportion cube (101);
- a second interface (403) for the reception of a second meshed proportion cube (101);
**characterized in that**:
- a circuit 404 adapted to perform the following, for each current column of the combined proportion cube for said current facies:
-- calculate a first value (205) that is a function of a sum of proportion values associated with the cells (202, 203, 204) of a column (201) in said first cube (101) corresponding to the current column;
-- calculate a second value (210) that is a function of a sum of proportion values associated with the cells (207, 208, 209) of a column (206) in said second cube (102) corresponding to the current column;
-- if the first value (205) is less than or equal to the second value (210), associate a proportion value with each current cell j among the cells in the current column (212, 213, 214) taken in increasing order of j, this proportion value being the minimum among:
--- a difference (214a) between the first calculated value (205) and the sum of proportion values associated with cells k in the current column, where k is an integer within the [1, j-1] interval;
--- a proportion value (214b) associated with a cell corresponding to the current cell (209) in the second proportion cube;
--- a difference (214c) between a maximum predetermined value and a sum of proportion values associated with a corresponding cell for each combined proportion cube for a facies m where m is an integer within the [1,i-1] interval;
-- if the first value (205) is larger than the second value (210), take each current cell j (215, 216, 217) among the cells in the current column and associate a proportion value with it, as a function of the average of a proportion value associated with a cell (204, 203, 202) corresponding to the current cell in the first proportion cube and a proportion value associated with a cell (209, 208, 207) corresponding to the current cell in the second proportion cube.

4. Computer program containing instructions for implementing the method according to either of claims 1 and 2 when the program is executed by a processor.
